# EUROPEAN PATENT APPLICATION

(11) **EP 2 320 257 A2**
(43) Date of publication of application: **11.05.2011**
(21) Application number: 10014465.8
(22) Date of filing: 10.11.2010
(51) Int. Cl.: G02B 6/293, H01S 5/028, H01S 5/34

(54) **Anti-reflection coated quantum dot resonator for wavelength division multiplexing optical communication**

(30) Priority: 10.11.2009 KR 20090107898
(71) Applicant: LG-Ericsson Co., Ltd., Seoul (KR)
(72) Inventor: Rhy, Hee Yeal, Uiwang-si Gyeonggi-do 437-080 (KR)
(74) Representative: Katérle, Axel

(57) **Abstract**

An AR coated quantum dot resonator (10) implementing a wavelength independent light source to resolve a drawback of degradation in the property of a high temperature optical output due to AR coating of LED or wavelength locked light source, which is filtered to a narrow line width, is disclosed. In one embodiment, a gain medium (13) includes at least one quantum dot and an anti-reflection (AR) coated reflection plane (12,15) at one of front (15) and rear planes (12) of the gain medium (13). The gain medium (13) has a wide line width due to different sizes and distribution of a plurality of quantum dots. The line width includes entire wavelength channels of a WDM or WDM-PON. Also, the AR coated reflection plane is a front reflection plane having a lower reflectivity (e.g., 0.001 % to 1 %.) than that of a rear reflection plane.

## Description

### CROSS-REFERENCE TO RELATED APPLICATIONS

The present application claims priority from Korean Patent Application No. 10-2009-0107898 (filed on November 10, 2009), the entire subject matters of which are incorporated herein by reference.

### TECHNICAL FIELD

The present invention relates to a wavelength division multiplexing passive optical network (WDM-PON), and more particularly to an anti-reflection (AR)-coated quantum dot resonator for implementing a wavelength independent light source. Also, the wavelength independent light source is used in light transmitter/receiver and an optical transmission system.

### BACKGROUND

A color-free light source (i.e., a wavelength independent light source) to configure WDM-PON can be implemented by using among others, two methods: 1) method of using a wavelength locked light source and 2) method of filtering a light emitting diode (LED) light source to a narrow line width.

The method of using the wavelength locked light source is as follows. It is possible to communicate using a Fabry Perot Laser Diode (FP-LD), which has a resonance wavelength band and includes sufficient wavelength bands to be used, (i.e., wide resonance bandwidth), as a transmitter by using all resonance spectra. A wavelength locked FP-LD may be implemented by injecting a light of an incoherent light source into the FP-LD resonated in a multi-mode to thereby lock resonance wavelengths of the FP-LD onto wavelengths of the incoherent light source. In such a case, a high power LED, an Erbium-doped fiber amplifier (EDFA) emitting amplified spontaneous emission (ASE), a superluminescent light-emitting diode (SLD), etc. may be employed as a broadband incoherent light source. In order to use the FP-LD for WDM or WDM-PON, however, it is necessary to adopt a filter having a narrow line width, such as a multiplexer (MUX), to select a part of wavelength channel areas from the wideband light source. In such a case, sufficient transmission performance may not be obtained due to a beating noise between a plurality of FP-LD resonance modes on wide resonance bandwidths or a mode partition noise. In this case, if the light of the wideband light source, which has passed through the filter, is injected into the FP-LD, then a few of FP-LD resonance modes included in the narrow line width of a corresponding wavelength channel are selectively resonated and other modes are suppressed, so that the light source provides sufficient transmission performance for transmission of a narrow line width.

In addition, the principle of operation of the LED filtered in a narrow line width is as follows. Since LEDs with a wide bandwidth do not meet the lasing conditions, the partition noise is very small. Thus, light resulting from passing through a filter having a narrow line width, such as a multiplexer, has a noise property suitable for transmission.

However, in order to obtain sufficient transmission performance as a wavelength locked light source, it is necessary to provide an AR coating of less than 1 % on the front plane of the FP-LD in the direction along which the light from an external light source is injected. In consideration of the noise property, an AR coating of less than 0.5 % for 125 Mbps transmission and an AR coating of less than 0.1 % for 1Gbps transmission are needed.

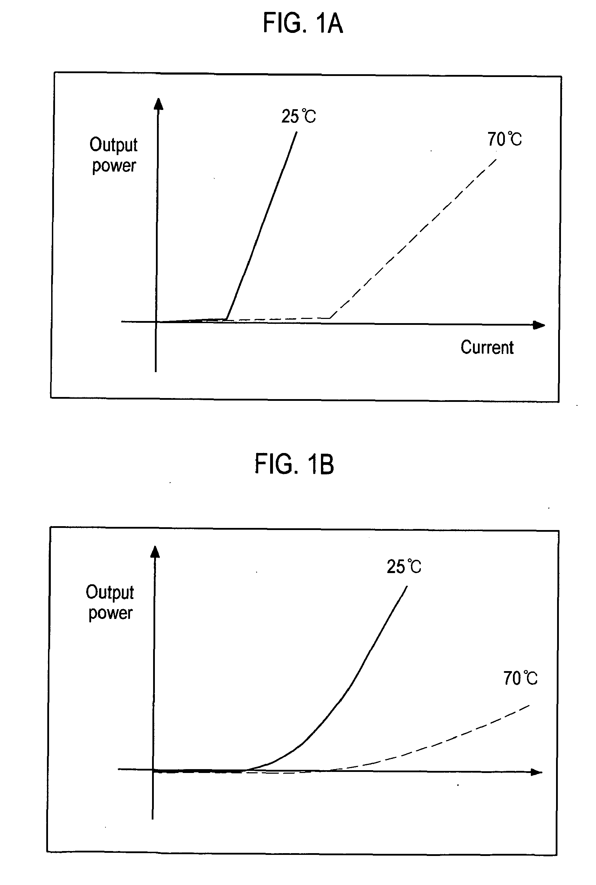

Generally, an optical output property of a typical FP-LD without AR coating is shown in FIG. 1A. As the operation temperature increases, the threshold current generally increases and the slope efficiency decreases. However, since degradation of the optical output is relatively low at a high temperature, it is possible to manufacture an optical transmitter, which is operable at an environmental condition in a central office (0 - 70 °C) and an outside environmental condition (-40 - 85 °C). However, if the front plane of FP-LD is AR coated for use as a wavelength locked light source, the threshold current increases at the same temperature compared to a typical FP-LD and slope efficiency decreases, as shown in FIG. 1B. If the AR coating on the front plane of the FP-LD decreases the reflectivity, the high-temperature optical output property degrades substantially as indicated by a dotted line in FIG. 1B and a thermoelectric device should be added for use in an outside environmental condition (-40 - 85 °C) for manufacturing the optical transmitter, with a resulting drawback of increased cost.

Also, when the wavelength independent light source is implemented using an LED filtered in a narrow line width, the output of the light source exhibits random directivity so that coupling efficiency of an optical fiber is lowered. Thus, there is a drawback that the efficiency of the output of the light source compared to the input is low. As a method to enhance the efficiency of the output of the light source to the input, the light source may used by providing an AR coating on the front plane and operating at near lasing conditions. However, even in such a case, since the high-temperature property is also degraded similar to the AR coated FP-LD case above, a thermoelectric device should be added for manufacturing optical transmitters with a resulting drawback of increase in manufacturing cost.

### SUMMARY

It is an object of the present invention to provide an AR coated quantum dot resonator for implementing a wavelength independent light source by resolving the drawback in degradation of high-temperature optical output property due to LED filtered in a narrow line width or AR coating of a wavelength locked light source.

It is another object of the present invention to apply an AR coated quantum dot resonator for implementing a wavelength independent light source to an optical transmitter/receiver and an optical transmission system.

In accordance with an aspect of the present invention, an AR coated quantum dot resonator is disclosed that resolves the drawback of degradation in high-temperature optical output property due to LED filtered in a narrow line width or AR coating of a wavelength locked light source. According to the present invention, there is provided a quantum dot resonator comprising a gain medium including at least one quantum dot and an anti-reflection (AR) coated reflection plane at one of the front and rear planes of the gain medium.

The gain medium contains different size and distribution of a plurality of quantum dots to have a wide line width and the line width includes entire wavelength channels of WDM or WDM-PON. Also, the AR coated reflection plane is a front reflection plane having a lower reflectivity (e.g., 0.001 % ∼ 1 %) than that of a rear reflection plane.

### BRIEF DESCRIPTION OF THE DRAWINGS

FIG. 1A is a graph showing output power characterstics of an FP-LD.

FIG. 1B is a graph showing output power characteristics of an AR coated FP-LD.

FIG. 2 is a schematic diagram showing an illustrative embodiment of light transmitter/receiver capable of using an AR coated quantum dot resonator.

FIG. 3 illustrates schematic diagrams showing structures of gain media and corresponding energy level behaviors.

FIG. 4A is a graph showing output power characteristics of an FP-1D using quantum dots.

FIG. 4B is a graph showing output power characteristics of an AR coated quantum dot resonator.

FIG. 5 shows an example of implementing a wavelength independent light source by using an optical transmitter of FIG. 2 according to a first illustrative embodiment.

FIG. 6 shows an example of implementing a wavelength independent light source by using an optical transmitter of FIG. 2 according to a second illustrative embodiment.

FIG. 7 is a schematic diagram showing an illustrative embodiment of a bidirectional module using a quantum dot resonator.

FIG. 8 is a schematic diagram showing an illustrative embodiment of a multi-wavelength WDM light source array using a quantum dot resonator.

FIG. 9 is a schematic diagram showing an illustrative embodiment of a multi-wavelength WDM light source array using a bidirectional module of FIG. 7

FIG. 10 is a schematic diagram showing an illustrative embodiment of the WDM transmission system using the optical transmitter/receiver of FIG. 2.

FIG. 11 is a schematic diagram showing a first illustrative embodiment of a WDM transmission system using a bidirectional module of FIG. 7.

FIG. 12 is a schematic diagram showing a second illustrative embodiment of a WDM transmission system using a bidirectional module of FIG. 7.

FIG. 13 is a schematic diagram showing a first illustrative embodiment of a WDM transmission system using an optical transmitter/receiver of FIG. 2 and the bidirectional module of FIG. 7

FIG. 14 is a schematic diagram showing a third illustrative embodiment of a WDM transmission system using the bidirectional module of FIG. 7.

FIG. 15 is a schematic diagram showing a second illustrative embodiment of a WDM transmission system using the optical transmitter/receiver of FIG. 2 and the bidirectional module of FIG. 7.

### DETAILED DESCRIPTION

Hereinafter, this detailed description is provided for illustrative embodiments with reference to the accompanying drawings. However, detailed descriptions of well-known functions or features are omitted so as not to unnecessarily obscure the subject matter of the present invention below.

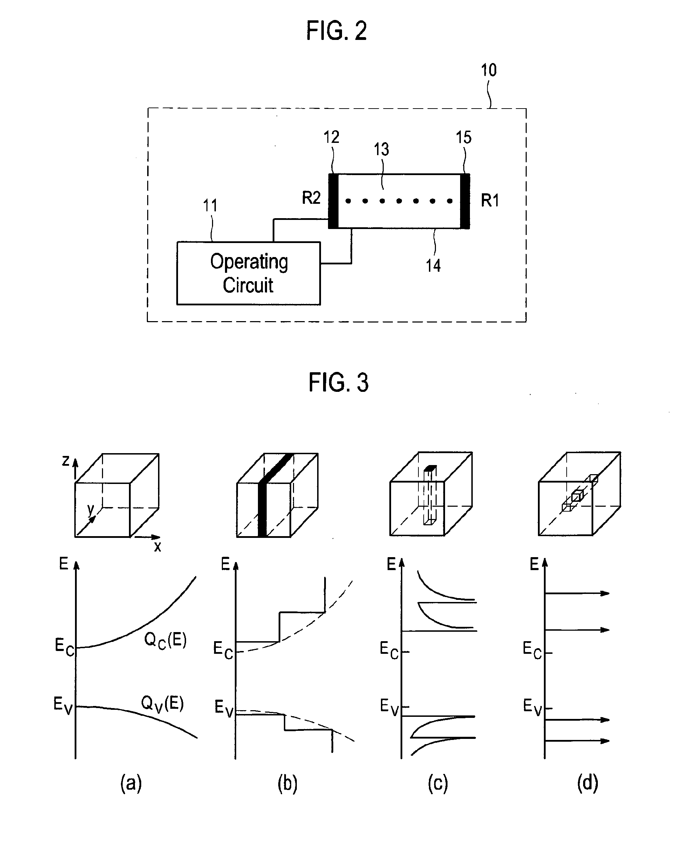

FIG. 2 is a schematic diagram showing an illustrative embodiment of a light transmitter/receiver in which an AR coated quantum dot resonator can be implemented.

The AR coated quantum dot resonator 14 may be applied to a light transmitter (or a light receiver 10) by implementing a wavelength independent light source.

To implement the wavelength independent light source, the AR coated quantum dot resonator 14 includes a gain medium 13 containing at least one quantum dot and an AR coated reflection plane, which is one of the front and rear planes 12 and 15 of the gain medium 13. The AR coated quantum dot resonator 14 may be an FP-LD and a quantum dot laser diode (QD-LD). An operating circuit 11 for operating the light source is configured as a transmitting circuit (or receiving circuit) and is connected to the quantum dot resonator 14 for use as a transmitter (or receiver) for optical communication.

Generally, the performance and properties of a gain medium of a semiconductor laser may be classified according to the spatial structure into a bulk type (a), a quantum well type (b), a quantum wire (c) and a quantum dot type (d) as shown in FIG. 3. The performance and properties of the gain medium, i.e., a quantization degree thereof are determined according to the spatial confinement of electrons and holes, which generate light from the semiconductor gain medium. A quantum well structure, which is widely used in the optical communication field recently, has a drawback in that the operation property of the output power is bad at a high temperature, as shown in FIGS. 1A and 1B. In constrast, in the quantum dot structure (d), since carriers, such as electrons or holes, are confined to a mimimum energy level (e.g., ground state) having considerably narrow distribution, thermal excitation to an upper energy level may be suppressed.

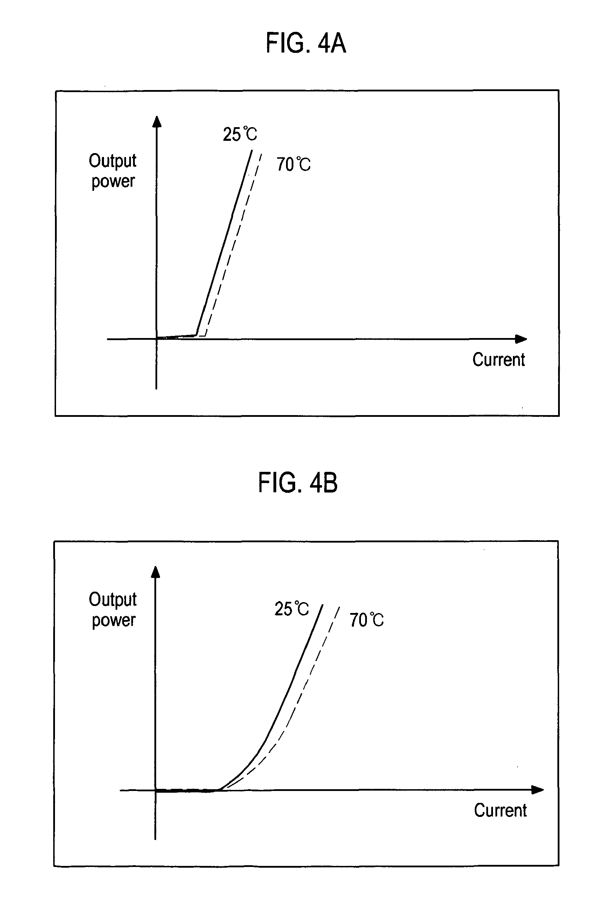

Therefore, the gain medium 13 having the quantum dot structure may exhibit considerably stable thermal operation properties. Compared to the output power properties relating to temperature for the FP-LD (see FIG. 1A) and AR coated FP-LD (see FIG. 1B), which have a quantum well structure, FP-LD and AR coated quantum dot resonators using quantum dots exhibit thermally excellent operation properties as shown in FIG. 4A and FIG. 4B.

In one embodiment, the gain medium 13 may be formed to have multiple quantum dots through a self-assembled method. The quantum dots may be formed by well-known methods. When the quantum dots are formed, thermally excellent operation properties may be exhibited, however, a narrow line width follows. In order to use the quantum dot resonator 14, which includes the gain medium with the quantum dots formed, in WDM or WDM-PON, the quantum dot resonator 14 should have a gain line width by the number of wavelengths to be used. While quantum dots have a considerably narrow line width, wavelengths of the quantum dots are determined by the size and distribution of the quantum dot structure. Thus, if the multiple quantum dots contained in the gain medium 13 are designed to have different sizes and distribution, the gain medium 13 will have a wide line width. That is, the line width may be widened by adjusting the size and distribution of the quantum dots contained in the gain medium 13. For example, if the gain medium 13 has a narrow line width of 1310 nm - 1480 nm in the case of a uniform size of the quantum dots, the line width may be extended to a wide line width of 980 nm - 1660 nm by adjusting the size and distribution of the quantum dots. However, since the wavelengths may be concentrated to a single wavelength due to the energy level property of the quantum dots (see FIG. 3 (d)), one of the reflection planes 12 and 15 of the front plane and the rear plane of the gain medium 13 with the quantum dots formed is AR coated to have low reflectivity to avoid the single wavelength concentration (it is for implementing multi-wavelength transmitter/receiver). If the AR coating is performed, the concentration on a single wavelength, i.e., a peak, disappears. In one embodiment, the AR coating is applied on the reflection plane 15 of the front plane of the quantum dot gain medium 13. The AR coated front reflection plane 15 has a lower reflectivity than that of the rear reflection plane 12. In one embodiment, the reflectivity of the reflection plane of the front plane has a value ranging from 0.001 % to 1 %.

In order to use the quantum dot resonator 14 suitably in WDM or WDM-PON, the line width has been widened by adjusting the sizes and distribution of the quantum dots and the AR coating has been applied to avoid the concentration of the wavelengths. To use the quantum dot resonator 14 in an optical communication device, electrodes as well as optical packaging are needed. The operating circuit 11 for operating the light source may be configured as a transmitting circuit for optical communication for use in a transmitter for optical communication or a receiving circuit for optical communication for use in a receiver for optical communication.

As illustrated in FIG. 4A, variations in threshold current and slope efficiency of the FP-LD using the quantum dots are very small even when the temperature varies from a room temperature (e.g., 25 °C) to a high temperature (e.g., 70 °C), which is different from a typical FP-LD (see FIG. 1A). Thus, as shown in FIG. 4B, since the AR coated quantum dot resonator 14 exhibits only small variations in the output power property even when the temperature varies from the room temperature (e.g., 25 °C) to the high temperature (e.g., 70 °C), which is different from that of the AR coated FP-LD (see FIG. 1B), it is possible to fabricate an optical transmitter at a high temperature without an additional thermoelectric device. Thus, it is advantageous in terms of low cost. When a wideband light source is formed by using the AR coated quantum dot resonator 14, there is an additional advantage that transmission performance is enhanced due to a low relative intensity noise of the quantum dot gain medium 13.

A wavelength independent light source for WDM may be implemented by using the optical transmitter 10 including the AR coated quantum dot resonator 14 of FIG. 2. The light source operates at a lasing condition or near the lasing condition. In one embodiment, the light source operates at a current higher than half of the threshold current corresponding to the lasing condition.

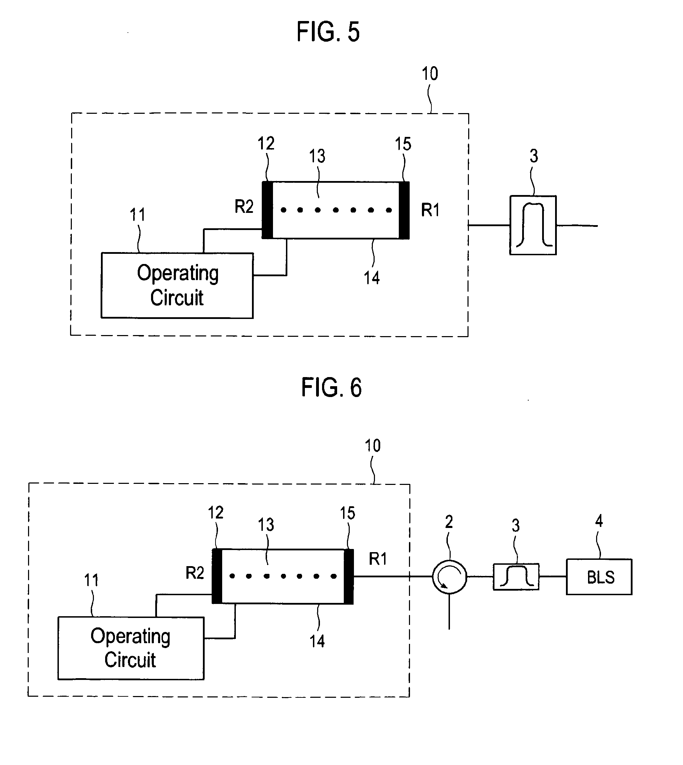

FIG. 5 shows an example of implementing the wavelength independent light source by filtering the light source of the light transmitter 10 to a narrow line width. In FIG. 5, a filter 3 has a narrow line width for selecting only a part of wavelength channels.

The filter 3 with a narrow line width property selects a specific wavelength channel among outputs having a wide line width from the AR coated quantum dot resonator 14, which is used as a transmitter for optical communication, and provides one of the wavelength channels of the WDM or WDM-PON system. Since the optical transmitter 10 including the AR coated quantum dot resonator 14 may be identically used in the entire wavelength channels of the WDM or WDM-PON system, it may be used as a wavelength independent light source. Since the optical transmitter 10 has a wide line width due to the gain medium 13 with variable sizes and distribution of the quantum dots, it may be used with respect to all wavelength channels of the corresponding line width. Thus, a single optical transmitter 10 may be used without the need for an additional optical transmitter 10 for each of the wavelength channels.

FIG. 6 shows an example of implementing a wavelength independent light source by a wavelength locked light source using the AR coated quantum dot resonator 14. In addition to the optical transmitter 10 including the quantum dot resonator 14, the wavelength independent light source may further include a wideband light source 4, a filter 3 having a narrow line width and an optical circulator 2.

The light from a wide band light source 4 including sufficient wavelength bands to be used passes through the filter 3 having a narrow line width and the optical circulator 2 to produce light with a narrow line width at a specific wavelength channel that is applied to the AR coated quantum dot resonator 14 to be used in a transmitter for optical communication to thereby amplify the wideband light source at a specific wavelength channel, so that the wideband light source may be used as a wavelength locked light source for the WDM or WDM-PON. Since the optical transmitter 10 including the AR coated quantum dot resonator 14 may be identically used in the entire wavelength channels of the WDM or WDM-PON system, it may be used as the wavelength independent light source. Since the optical transmitter 10 has a wide line width by including the gain medium 13 in which the quantum dots have different sizes and distribution, it may be used with respect to the entire wavelength channels of the corresponding line width. Thus, a single optical transmitter 10 may be used without using an additional optical transmitter 10 for each of wavelength channels.

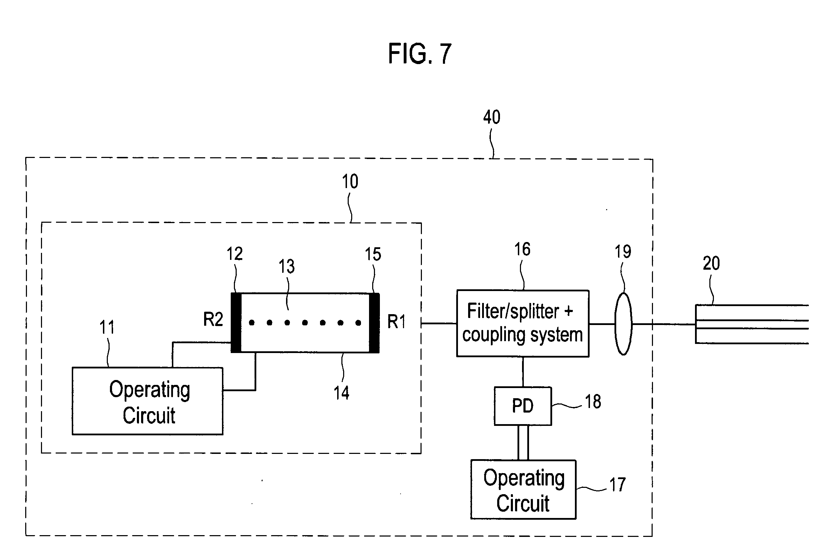

FIG. 7 is a schematic diagram showing an illustrative embodiment of a bidirectional module using a quantum dot resonator.

In addition to the optical transmitter 10 having an AR coated quantum dot resonator 14, the bidirectional module 40 includes a receiving element (photo diode, PD) 18, an operating circuit 17 for operating the photo diode 18, a filter/splitter 16 for forming and separating optical paths between an optical transmitter 10, the receiving element 18 and an optical fiber 20, and a coupling optical system having a lens 19. A wavelength independent bidirectional optical transmitter/receiver using a wideband light source filtered to a narrow line width may be configured by adding the filter 3 having the narrow line width, which is shown in FIG. 5, to the bidirectional module 40 for optical communication. Also, a wavelength locked and wavelength independent bidirectional transmitter/receiver may be configured by adding the wideband light source 4 and the filter having the narrow line width and the optical circulator 2, which are shown in FIG. 6, to the bidirectional module 40 for optical communication.

The operating circuit 11 may be configured as a typical transmitting circuit for optical communication to allow the AR coated quantum dot resonator 14 to operate as the optical transmitter 10. If the operating circuit 17 for operating the receiving element 18 is configured as a receiving circuit for optical communication, the receiving element 18 and the operating circuit 17 may operate as an optical receiver. Also, if different wavelength bands are used in the optical transmitter 10 and the optical receivers 17 and 18, and the filter/splitter 16 is used, wideband light signals output from the optical transmitter 10 are coupled to the optical fiber 20 via the filter/splitter 16 and the lens system 19 for transmission to a higher level WDM or WDM-PON system, and light signals of the higher level WDM or WDM-PON system, which uses different wavelength bands from the optical transmitter 10, are transmitted to the optical receivers 17 and 18 from the optical fiber 20 through the lens system 19 and the filter/splitter 16.

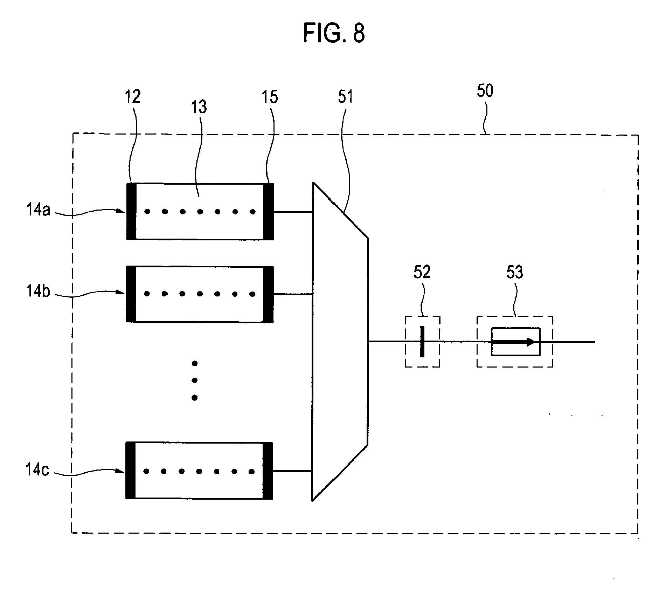

FIG. 8 is a schematic diagram showing an illustrative embodiment of a multi-wavelength WDM light source array using the quantum dot resonator.

The multi-wavelength WDM light source array 50 includes a plurality of AR coated quantum dot resonators 14a, 14b and 14c, which are arranged in parallel, and a wavelength multiplexer, which are configured with arrayed waveguide grating or a thin film multiplexer (MUX), where the plurality of quantum dot resonators 14a, 14b and 14c are connected to optical paths of the wavelength multiplexer 51. Also, an optical transmitting circuit (not shown) for optical communication may be installed on each of the AR coated quantum dot resonators 14a, 14b and 14c, so that a plurality of optical transmitters 10 are formed, and the multi-channel WDM optical transmitter may be formed by connecting the plurality of optical transmitters 10 to the optical paths of the wavelength multiplexer 51. Also, a reflector 52 may be additionally installed to lock a wavelength of each of the quantum dot resonators 14a, 14b and 14c to a wavelength channel of the multiplexer 51. Further, an optical isolator 52 may be additionally installed to prevent degradation due to retroreflection under the environmental condition of the multi-wavelength WDM light source array 50.

The multi-wavelength WDM light source array 50 may be miniaturized by using a planar lightwave circuit (PLC) technology.

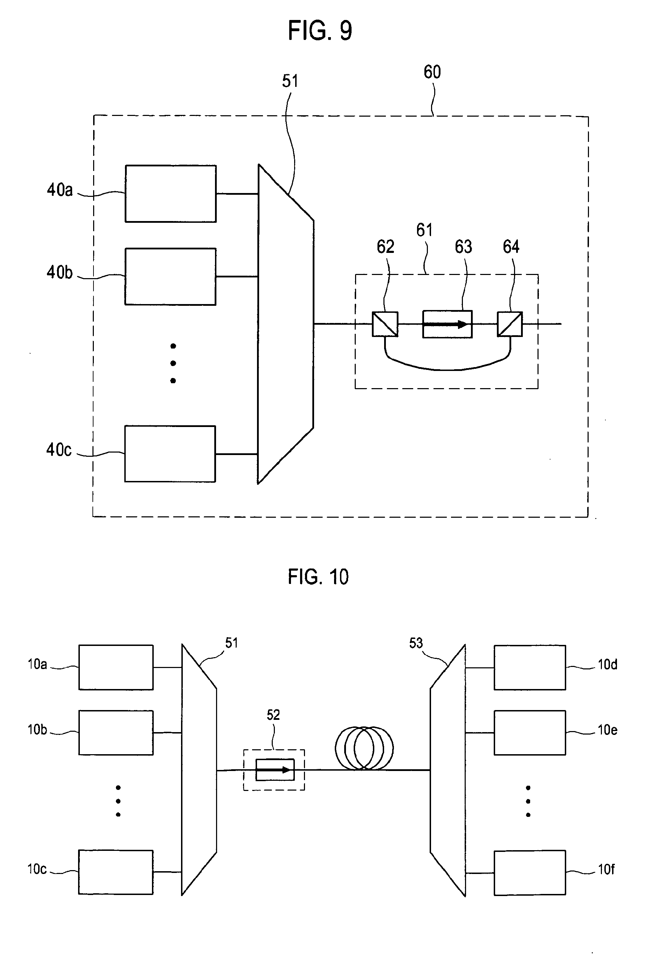

FIG. 9 is a schematic diagram shown an illustrative embodiment of the multi-channel WDM transmission/reception array using the bidirectional module of FIG. 7.

The multi-channel WDM light source array 60 may be configured to include a plurality of bidirectional modules 40a, 40b and 40c arranged in parallel, and a wavelength multiplexer/demultiplexer 51 configured with arrayed waveguide grating or a thin film multiplexer (MUX), where the plurality of bidirectional modules 40a, 40b and 40c are connected to optical paths of the wavelength multiplexer/demultiplexer 51. An optical isolator 63 may be additionally installed on a back side of the wavelength multiplexer/demultiplexer 51 to prevent degradation due to retroreflection under the environmental condition of the system using the multi-channel WDM light source array 60, and a wavelength selective optical isolator 61 configured with wavelength division couplers 62 and 64 for dividing wavelengths of the bidirectional modules 40a, 40b and 40c, may be further installed. Also, the multi-channel WDM light source array 60 may be miniaturized by using the PLC technology.

The optical transmitter 10 including the AR coated quantum dot resonator 14 in each of the bidirectional modules 40a, 40b and 40c outputs light signals corresponding to each wavelength channel, and the output light signals are multiplexed by the wavelength multiplexer/demultiplexer 51 for transmission to the a higher level system of the WDM or WDM-PON. Also, multi-channel wavelength light signals transmitted from the system using different wavelength bands from the optical transmitter 10 included in each of the bidirectional modules 40a, 40b and 40c are demultiplexed by the wavelength multiplexer/demultiplexer 51, and the demultiplexed channel wavelengths are transmitted to the corresponding bidirectional modules 40a, 40b and 40c. The demultiplexed channel wavelengths are transmitted to the optical receiver 17, 18 by the filter/splitter 16 in each of the bidirectional modules 40a, 40b and 40c. In this case, wavelength division couplers 62 and 64 and an optical isolator 63 may additionally be used for suppressing an affect of retroreflection of the system. That is, the wavelength multiplexed light signals are transmitted to the system via the wavelength filter 62, the optical isolator 63 and the wavelength filter 64 in a sequential manner, and the multi-channel wavelength light signals, which are transmitted form the system using different wavelength bands from the optical transmitter 10 included in each of the bidirectional modules 40a, 40b and 40c, are transmitted by passing the wavelength filter 64 and the wavelength filter 62 in a sequential manner. In such a case, since the optical transmission paths are different, the optical isolator 63 is not passed.

One of ordinary skill in the WDM or WDM-PON may form various optical transmission systems by single or combination of the plurality of optical transmitters (or optical receivers) 10 including the AR coated quantum dot resonator 14 or a plurality of bidirectional modules 40 including the optical transmitter/receiver 10.

FIG. 10 is a schematic diagram showing an illustrative embodiment of the WDM transmission system using the optical transmitter/receiver of FIG. 2.

As shown in FIG. 10, the WDM optical transmission system may be configured by including a plurality of transmitters 10a, a0b and 10c including the AR coated quantum dot resonator 14, the wavelength multiplexer/demultiplexers 51 and 53 formed by arrayed waveguide grating or a thin filter type of multiplexer/demultiplexer, and a plurality of optical receivers 10d, 10e and 10f including the AR coated quantum dot resonator 14. Also, an optical isolator 52 may be added at one side of the transmitter/receiver to prevent degradation of the optical transmission system due to retroreflection.

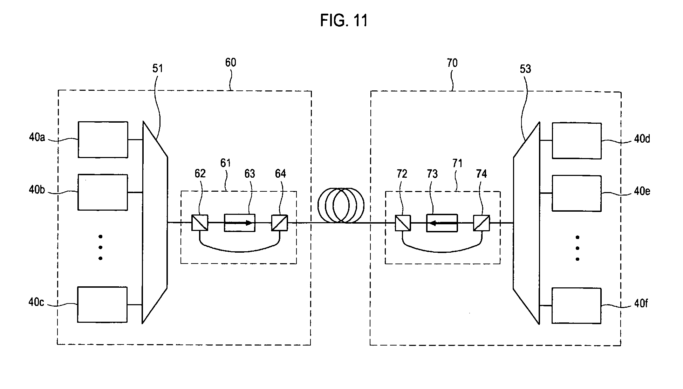

FIG. 11 is a schematic diagram showing a first illustrative embodiment of a WDM transmission system using the bidirectional module of FIG. 7.

The structure of one side of the transmitting/receiving unit is identical to that of the multi-channel WDM transmission/reception array 60 of FIG. 9. The multi-channel WDM transmission/reception array 70 includes a plurality of bidirectional modules 40d, 40e and 40f, which are arranged in parallel and connected to optical paths of a wavelength multiplexer/demultiplexer 53 formed by arrayed waveguide grating or a thin film type of multiplexer. To prevent degradation due to retroreflection under the environmental condition of the system, the multi-channel WDM transmission/reception array 70 may be configured with a wavelength selective optical isolator 71 provided on a back side of the wavelength multiplexer/demultiplexer 53. The wavelength selective optical isolator 71 may include an optical isolator 73 and wavelength division couplers 72 and 74 for dividing wavelengths of the bidirectional modules 40d, 40e and 40f. Also, the multi-channel transmission/reception array 70 may be miniaturized by using the PLC technology.

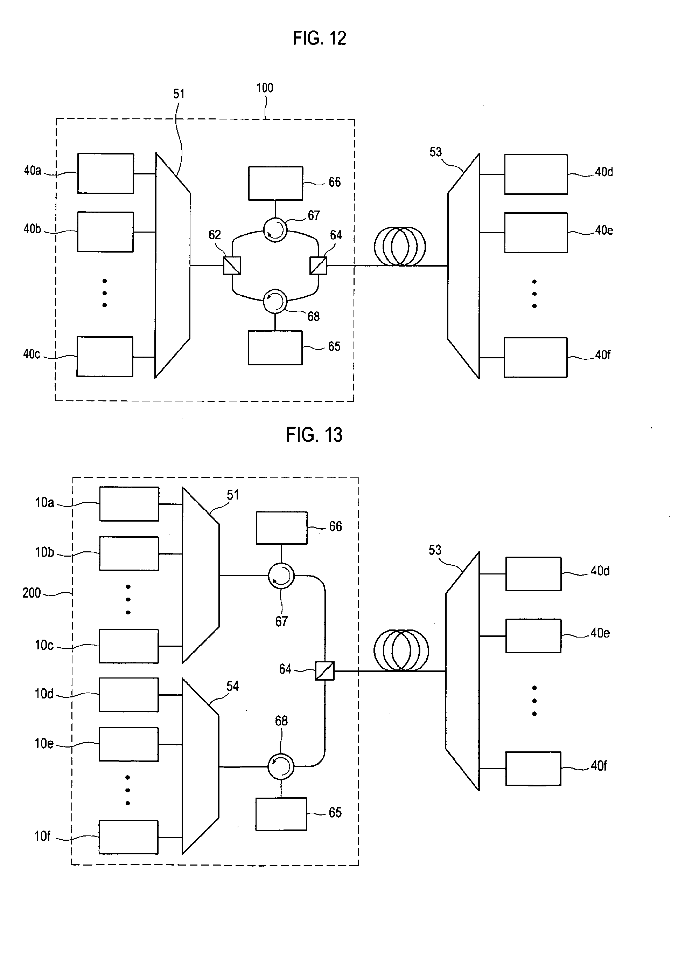

FIG. 12 is a schematic diagram showing a second illustrative embodiment of a WDM transmission system using the bidirectional module of FIG. 7. For example, one transmitting/receiving unit is a device 100 for use in a central office and the other transmitting/receiving unit is a device for use in a remote node.

As shown in FIG. 12, the transmitting/receiving device 100 for use in the central office may include a plurality of bidirectional modules 40a, 40b and 40c containing the optical transmitter/receiver 10, the wavelength multiplexer/demultiplexer 51 formed by array waveguide grating or a thin film filter type of multiplexer/demultiplexer, a plurality of wavelength division couplers 62 and 64, a plurality of optical circulators 67 and 68, and a plurality of wideband light sources 65 and 66. The transmission/reception unit on the remote side may include a plurality of bidirectional modules 40d, 40e and 40f, which are arranged in parallel and connected to optical paths of the wavelength multiplexer/demultiplexers 53 formed by array waveguide grating or a thin film filter type of multiplexer/demultiplexer. FIG. 12 illustrates one embodiment of a wavelength locked bidirectional WDM transmission system.

In other embodiments, the wavelength locked bidirectional WDM transmission system may be configured as shown in FIG. 13 to FIG. 15.

FIG. 13 is a schematic diagram showing a first illustrative embodiment of a WDM transmission system using the optical transmitter/receiver of FIG. 2 and the bidirectional module of FIG. 7. In one embodiment, the transmitting/receiving unit is a device 200 for use in the central office and the other side is a device at a remote node side.

As shown in FIG. 13, a transmitting/receiving device 200 for use in the central office may include a plurality of optical transmitters 10a, 10b, 10c, 10d, 10e and 10f containing the AR coated quantum dot resonator 14, a plurality of wavelength multiplexer/demultiplexers 51 and 54 formed by arrayed waveguide grating or a thin film filter type of multiplexer/demultiplexer, a wavelength division coupler 64, a plurality of optical circulators 67 and 68, and a plurality of wideband light sources 65 and 66. The other side of the transmitting/receiving unit may be identically configured as the remote side of the transmitting/receiving unit in FIG. 12.

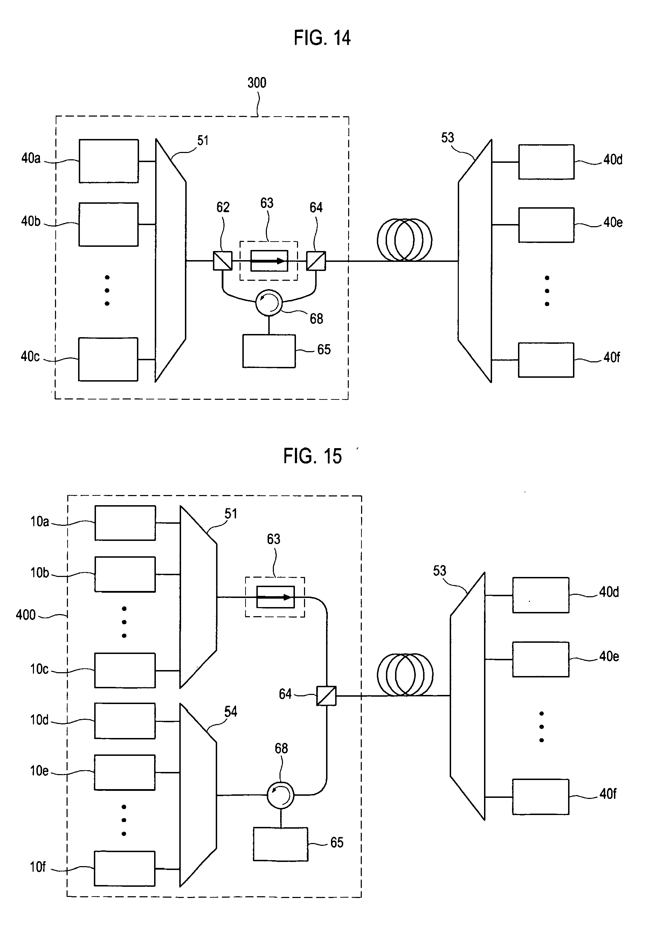

FIG. 14 is a schematic diagram showing a third illustrative embodiment of a WDM transmission system using the bidirectional module of FIG. 7.

As shown in FIG. 14, a transmitting/receiving device 300 for use in the central office may include a plurality of bidirectional modules 40a, 40b and 40c containing the optical transmitter/receiver 10, the wavelength multiplexer/demultiplexers 51 formed by array waveguide grating or a thin film filter type of multiplexer/demultiplexer, a plurality of wavelength division couplers 62 and 64, an optical circulator 68, and a wideband light source 65. An optical isolator 63 may be additionally provided to suppress the retroreflection of the system. The other side of the transmitting/receiving unit is identically configured to that of the remote side of the transmitting/receiving units of FIG. 12 and FIG. 13.

FIG. 15 is a schematic diagram showing a second illustrative embodiment of a WDM transmission system using the optical transmitter/receiver of FIG. 2 and the bidirectional module of FIG. 7.

As shown in FIG. 15, a transmitting/receiving device 400 for use in the central office may include a plurality of optical transmitters 10a, 10b, 10c, 10d, 10e and 10f containing the AR coated quantum dot resonator 14, a plurality of wavelength multiplexer/demultiplexers 51 and 54 formed by array waveguide grating or a thin film filter type of multiplexer/demultiplexer, a wavelength division coupler 64, an optical circulator 68, and a wideband light source 65. The other side of the transmitting/receiving unit may be identically configured to that of the remote side of the transmitting/receiving units in FIG. 12 to FIG. 14. In FIG. 15, a bidirectional WDM optical transmission system may be configured to implement a wideband light source filtering method and a wavelength locking method.

Although embodiments have been described with reference to a number of illustrative embodiments thereof, it should be understood that numerous other modifications and embodiments can be devised by those skilled in the art that will fall within the spirit and scope of the principles of this disclosure. More particularly, numerous variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A quantum dot resonator comprising:
a gain medium containing at least one quantum dot; and
an anti-reflection (AR) coated reflection plane at one of front and rear planes of the gain medium.

2. The quantum dot resonator of Claim 1, wherein the gain medium contains different size and distribution of a plurality of quantum dots to have a wide line width.

3. The quantum dot resonator of Claim 2, wherein the line width include entire wavelength channels of a WDM or WDM-PON.

4. The quantum dot resonator of Claim 2, wherein the AR coated reflection plane is a front reflection plane having a lower reflectivity than that of a rear reflection plane.

5. The quantum dot resonator of Claim 4, further comprising an operating circuit for operating a light source.

6. The quantum dot resonator of Claim 5, wherein the operating circuit is configured with a transmitting circuit for optical communication to be used in an optical transmitter.

7. The quantum dot resonator of Claim 6, further comprising a filter for filtering out the light source of the optical transmitter to a narrow line width to be used in a same optical transmitter with respect to the entire wavelength channels of WDM or WDM-PON for implementing a wavelength independent light source.

8. The quantum dot resonator of Claim 6, further comprising a wideband light source configured to inject light to the gain medium of the optical transmitter, a filter having a narrow line width and configured to select a part of wavelength channels from the wideband light source, and an optical circulator configured to form an optical path for directing the wideband light source to the optical transmitter for amplification at specific channels to be used as a wavelength locked light source and to be used in a same optical transmitter with respect to the entire wavelength channels of WDM or WDM-PON for implementing a wavelength independent light source.

9. The quantum dot resonator of Claim 6, further comprising an optical receiver and a device configured to form and divide an optical path between the optical transmitter and the optical receiver to configure a bidirectional optical module.

10. The quantum dot resonator of Claim 4, wherein the quantum dot resonator is arranged in parallel and a wave multiplexer for multiplexing wavelengths of the respective quantum dot resonators for configuring a multi-wavelength optical transmission module.

11. The quantum dot resonator of Claim 10, further comprising a reflector adapted to lock the wavelengths of the respective quantum dot resonator to a wavelength of the wavelength multiplexer.

12. The quantum dot resonator of Claim 6, further comprising a wavelength multiplexer configured to multiplex the wavelength channels of the respective optical transmitter to thereby configure a multi-channel optical transmission module and wherein a plurality of the optical transmitters is arranged in parallel.

13. The quantum dot resonator of Claim 9, further comprising a wavelength multiplexer/demultiplexer configured to multiplex/demultiplex the wavelength channels of each of the bidirectional optical modules in a multi-channel optical transmitting/receiving module and wherein the bidirectional modules comprises a plurality of bidirectional modules arranged in parallel.

14. The quantum dot resonator of Claim 5, wherein the operating circuit is configured with a receiving circuit for optical communication for use in an optical receiver.

15. The quantum dot resonator of Claim 4, wherein the reflectivity of the front reflection plane has 0.001 % to 1 %.
